# EUROPEAN PATENT APPLICATION

(11) **EP 2 602 826 A1**
(43) Date of publication of application: **12.06.2013**
(21) Application number: 11192730.7
(22) Date of filing: 09.12.2011
(51) Int. Cl.: H01L 29/36, H01L 29/10, H01L 29/66

(54) **Insulated gate power semiconductor device and method for manufacturing such a device**

(71) Applicant: ABB Technology AG, 8050 Zürich (CH)
(72) Inventor: Bauer, Friedhelm, 6714 Semione (CH); Rahimo, Munaf, 5619 Uezwil (CH)
(74) Representative: ABB Patent Attorneys

(57) **Abstract**

An insulated gate power semiconductor device (1) is provided having
- an emitter electrode (2) on an emitter side (22) and a collector electrode (25) on a collector side (27),
- a drift layer (5) of a first conductivity type, which is arranged between the emitter side (22) and the collector side (27),
- a base layer (4) of a second conductivity type, which is arranged between the drift layer (5) and the emitter side (22), and which base layer (4) contacts the emitter electrode (2),
- at least one source region (3), which is arranged on the emitter side (22) and which contacts the emitter electrode (2),
- at least two trench gate electrodes (7), each of which trench gate electrodes (7) extends from the emitter side (22) up to a trench gate electrode depth (77),
- a delta enhancement layer (8) of the first conductivity type having higher doping concentration than the drift layer (5), which is arranged between two trench gate electrodes (7) in a region deeper from the emitter side (22) than the at least one source region (3) and shallower than the trench gate electrode depth (77) and buried within at least one of or between the base layer (4) and the drift layer (5),
wherein the delta enhancement layer (8) has a thickness (82) perpendicular to the emitter side (22) of at most 0.5 µm.

## Description

### Technical Field

The invention relates to the field of power electronics and more particularly to an insulated gate power semiconductor device according to the preamble of the independent claim 1 and to a method for manufacturing such a device.

### Background Art

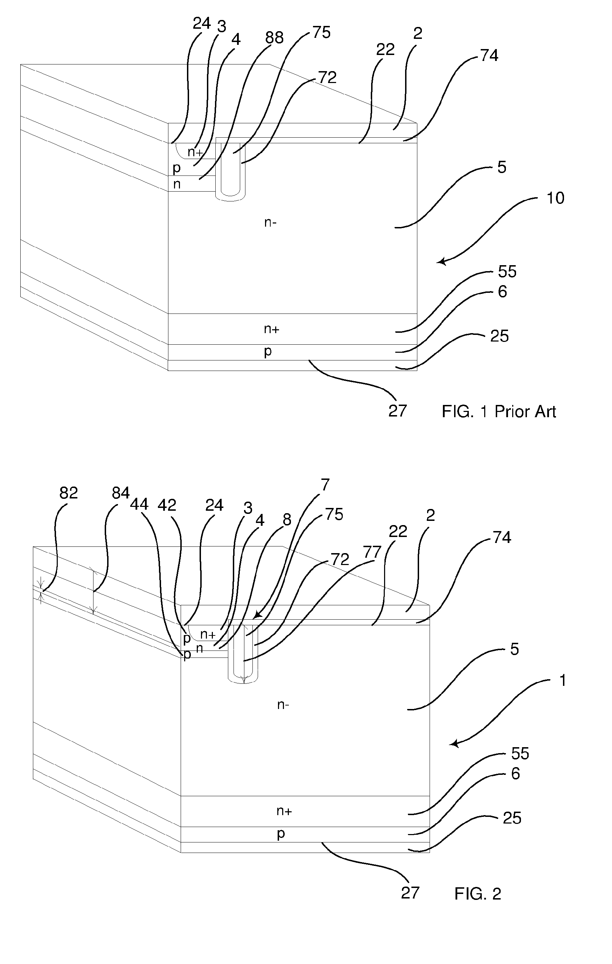

In Fig. 1 a prior art insulated gate bipolar transistor (IGBT) 10 is shown as known from the document "The carrier stored trench-gate bipolar transistor (CSTBT) - A novel power device for high voltage application by H. Takahashi et al., Proc. ISPSD'96, pp 349-352, USA, 1996, which comprises an active cell with layers of different conductivity types in the following order between an emitter electrode 2 on an emitter side 22 and a collector electrode 25 on a collector side 27 opposite to the emitter side 22: an (n+) doped source region 3, a p doped base layer 4, which contacts the emitter electrode 25 in a contact area 24, an n doped enhancement layer 88, an (n-) doped drift layer 5, an (n+) doped buffer layer 52 and a p doped collector layer 6.

A trench gate electrode 7 is arranged on the emitter side 22, which comprises an electrically conductive layer 75 and a first electrically insulating layer 72, which surrounds and thus separates the electrically conductive layer 75 from the drift layer 5, base layer 4 and the at least one source region 3. A second insulating layer 74 is arranged between the electrically conductive layer 75 and the emitter electrode 2.

The depth of the trench gate electrode known from H. Takahashi et al., Proc. ISPSD'96, pp 349-352, USA, 1996, is 7 µm, whereas the depth to which the source region extends is 1 µm, of the base layer 2.3 µm and of the enhancement layer 7 µm so that the enhancement layer 88 has a thickness of around 5 µm. Prior art devices having such an enhancement layer 88 are also called carrier stored trench-gate bipolar transistor (CSTBT). As the carrier concentration near the active cell is enhanced by such an enhancement layer 88, IGBTs 10 with such an enhancement layer 88 are superior compared to prior art IGBTs having no enhancement layer in view of higher safe operating area (SOA) and lower on-state losses.

The n-type enhancement layer 88 improves the carrier spreading from the cell by creating a barrier and reduces the amount of holes that can reach the emitter (PNP hole drainage effect). This improves the PIN effect, increases the plasma concentration and lowers the on-state losses. However, such a prior art CSTBT having a highly doped enhancement layer 88 will suffer from worse SOA, breakdown voltage and cosmic ray failure rate compared to standard trench IGBTs.

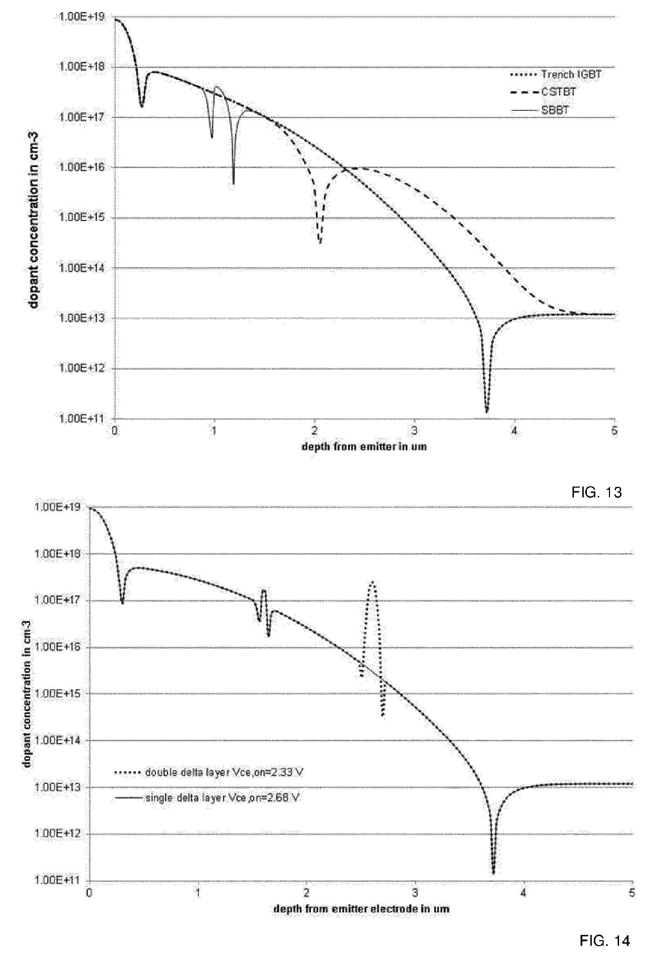

The enhancement layer 88 has a higher doping concentration than the drift layer 5 so that the electric field at the n-enhancement / p-base junction 88, 4 also increases. Practical enhancement layer doping concentrations are therefore limited to 1 * 10¹⁶ cm⁻³ to prevent excessive electric fields and therefore degradation of the blocking performance, turn-off SOA and cosmic ray failure rate (see curve for CSTBT in FIG 13).

As described in EP 0 795 911 A2 a prior art enhancement layer 88 is created by first implanting and diffusing N-dopants. Afterwards, P-dopants are implanted and diffused for creating the p doped base layer 4. The n+ source regions 3 are then created implanting dopants using a resist mask, which are then diffused and annealed. Subsequently, an oxide film is applied over the source regions 3 and partly over the base layer 4 for etching openings for the trench gate electrodes 7, which extend in depth down to the drift layer 5. Then the oxide film is etched away and a thermal oxide film (for forming the insulating layer 72) is formed on the surface of the trenches, which are then filled with polysilicon doped with N-impurities for creating an electrically conductive layer 75. The polysilicon is etched back to the openings of the trenches, leaving the polysilicon buried in the trenches. Then the surface is covered by a second insulating layer 74, which is afterwards covered by a resist layer as another mask, which covers the regions on top of the trenches, the source regions 3 besides a small open area, which lies directly adjacent to the base layer, 4 which is also uncovered. The second insulating layer 74 is then etched away at the uncovered resist mask areas, thus maintaining the second insulating layer 74 on top of the electrically conductive layer 75 and the adjacent part of the source regions 3. Afterwards AlSi is applied on the uncovered areas of the second insulating layer 74, by which AlSi layer, which forms the emitter electrode 2, the base layer 4 and source regions 3 are shorted.

### Disclosure of Invention

It is an object of the invention to provide a power semiconductor device, with low on-state losses, which provides a lower collector-emitter voltage V_{ce,on} compared to prior art devices while a high breakdown voltage is maintained.

This object is achieved by providing an inventive power semiconductor device comprising:
- an emitter electrode on an emitter side and a collector electrode on a collector side, which collector side is arranged opposite to the emitter side,
- a drift layer of a first conductivity type, which is arranged between the emitter side and the collector side,
- a base layer of a second conductivity type, which is different from the first conductivity type, which base layer is arranged between the drift layer and the emitter side, and which base layer contacts the emitter electrode,
- at least one source region, which is arranged on the emitter side and embedded into the base layer and which contacts the emitter electrode,
- at least two trench gate electrodes, each of which comprises an electrically conductive layer and a first electrically insulating layer, which surrounds and thus separates the electrically conductive layer from the drift layer, base layer and the at least one source region, wherein the trench gate electrode is arranged lateral to the base layer in a plane parallel to the emitter side, and which trench gate electrode extends from the emitter side up to a trench gate electrode depth,
- a delta enhancement layer of the first conductivity type having higher doping concentration than the drift layer, which is arranged between two trench gate electrodes in a region deeper from the emitter side than the depth, to which the at least one source region extends from the emitter side, and shallower than the trench gate electrode depth. The delta enhancement layer is buried within at least one of or between the base layer and the drift layer. The enhancement layer has a thickness of at most 0.5 µm.

The thickness of the delta enhancement layer is measured in a plane perpendicular to the emitter side. It is defined as such thickness in which the delta enhancement layer has a higher doping concentration than or overcompensates the doping of any of the attached layers, i.e. than the base layer and/or the drift layer.

The vertical distance from the bottom of source layer to the top of enhancement layer corresponds to the channel length of the controlling vertical MOS structure. To keep this contribution to total on-state voltage drop as low as possible, the channel length may be minimized, thus positioning of enhancement layer close to the emitter surface.

In an exemplary embodiment the delta enhancement layer has a doping concentration higher than 1 * 10¹⁶ cm⁻³, in a further exemplary embodiment even higher than 1 * 10¹⁶ cm³ or even higher than 1 * 10¹⁷ cm⁻³. This results in a more effective barrier, which blocks the hole flow into the emitter, thereby increasing the plasma concentration and reducing on-state losses. The higher dopant concentration of the delta enhancement layer in an inventive IGBT compared to a prior art enhancement layer in a CSTBT is shown in FIG 13, in which the prior art CSTBT is limited to a maximum doping concentration of the enhancement layer 88 of 1 * 10¹⁶ cm⁻³, whereas the inventive IGBT has maximum doping concentration of the delta enhancement layer 8 of 1 * 10¹⁷ cm⁻³.

In another alternative, the charge in the enhancement layer is further enhanced, so that the semiconductor device is a thyristor-like device (trench emitter switched thyristor: TEST) without short-circuit capability but still lower on-state voltage drop.

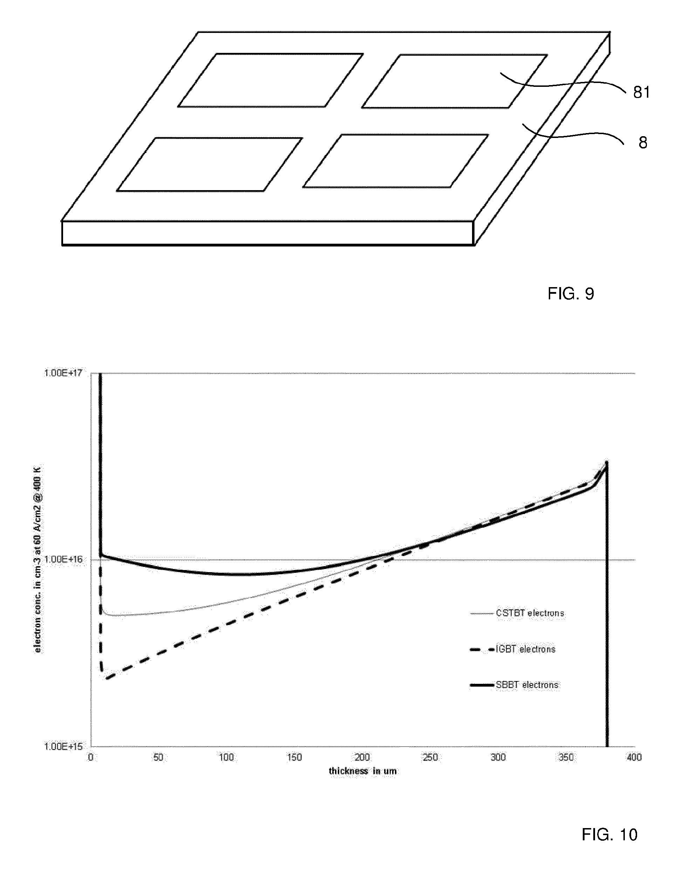

Like prior art CSTBT devices the inventive devices provide lower on-state voltage drop compared to prior art devices without delta enhancement layer. However, as the enhancement layer provides a homogeneous injection and distribution of electrons already very close to the emitter, the carrier modulation is thus much improved compared to the prior art CSTBT. FIG. 10 shows the electron density n per cm³ at 60 A/cm² at the center of the contact area between two trench gate electrodes. "Thickness" corresponds to the depth axis (direction from the emitter side 22 and perpendicular to the emitter side 22). The doping concentration for the curves shown in FIG. 10 are those shown in FIG. 13. CSTBT and the inventive device show similar electron densities in the center of the contact areas, but in an overall view over all positions the inventive device has even a more homogeneous electron current density, i.e. the inventive device allows to divert electrons and holes most efficiently to regions due to the delta enhancement layer, which regions are otherwise poorly conductively modulated. Due to the fact that the inventive delta enhancement layer can be positioned to any depth, the modulation can be improved in any desired depth. If, e.g. the modulation shall be improved in low depths, the delta enhancement layer can be positioned in such a depth without having to position the pn-junction in the same depth as it is the case for the prior art CSTBT devices. The base layer may, e.g., comprise a first sublayer and a second sublayer, one above each other in a plane parallel to the emitter side and in that the delta enhancement layer is arranged within the base layer between the first and second sublayer.

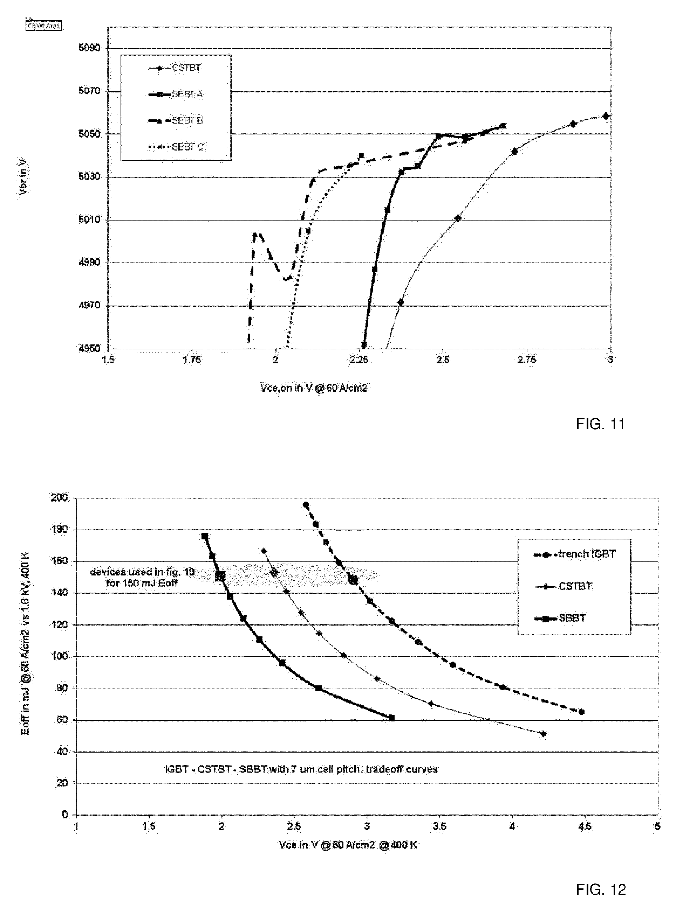

Compared to the CSTBT devices, the breakdown voltage reduction can be kept lower for such inventive devices. Without degrading the breakdown voltage V_{br} the collector-emitter on voltage V_{ce,on} can be strongly reduced as shown in FIG. 11. The doping concentration for the curves shown in FIG. 11 are those shown in FIG. 13 (SBBT C of FIG 11 corresponds to SBBT in FIG. 13).

Fig. 11 shows the reduction of V_{ce,on} for an inventive device SBBT-A compared to a prior art CSTST. Also a large safe operating area (SOA) can be maintained even at very low V_{ce,on}. Therefore, an inventive semiconductor device will not experience an increase of cosmic ray induced failure rates as typical for CSTBT-designs at very high doses of the enhancement layer.

The presence of the delta enhancement layer in the inventive device thus negatively affects characteristics like breakdown, SOA and cosmic failure rates to a much lesser degree as in a comparable CSTBT. Therefore, at the same SOA limit, the inventive devices can be manufactured with a more heavily doped delta enhancement layers than the CSTBT.

SBBT C has a shallower delta enhancement layer than SBBT A (doping concentration of SBBT A corresponds to the single delta enhancement layer shown in FIG. 14), resulting in better (lower) values for V_{ce}, on. For SBBT B and SBBT A the depths of the delta enhancement layers are the same, however, the doping of the delta layer is increased for SBBT B, thus reducing V_{ce,on}. In fig. 11 it is shown that both curves originate from the same point at 5054 V at 2.68 V, whereas SBBT B has advantageously lower V_{ce}, on for the lower breakdown voltage than the breakdown voltage stated above compared to SBBT A.

The inventive device may also comprise more than one enhancement layer. For a device having two or more enhancement layers modulation can also be increased gradually. It allows an improved or expanded design flexibility regarding the optimum trade-off between unaltered IGBT characteristics and further minimized on-state voltage drop compared to a device having one delta enhancement layer 82. The peak electric field around the enhancement layers 8, 86, 87 can be more uniformly distributed, thus reducing the peak electric field.

An inventive device having one delta enhancement layer up to a depth of 1.6 µm and a maximum doping concentration of 1.5 * 10¹⁷ cm⁻³ generates an on-state voltage drop of 2.68 V at 60 A cm⁻² and 400 K, whereas by adding a second delta enhancement layer in a depth up to 2.7 µm and a maximum doping concentration of 2*10¹⁷cm⁻³ V_{ce, on} can be reduced to 2.33 V. In this numerical example, the same SBBT structure without the second deeper implant would generate an on-state voltage drop of 2.68 V @ 60 A/cm2 and at 400 K. The addition of the second layer reduces Vce,on to 2.33 V.

FIG 12 shows the switching off energy losses E_{off} versus V_{ce, on} for a prior art trench IGBT, a prior art CSTBT and an inventive IGBT (designated as SBBT). The improvements from the standard trench IGBT over the CSTBT to the inventive IGBT having a delta enhancement layer is clearly shown in the figure. The doping concentration for the curves shown in FIG. 12 are those shown in FIG. 13.

The manufacturing of an inventive semiconductor device is much easier than for prior art devices and allows more freedom to apply doping concentrations as electrically advantageous because the inventive delta enhancement layer can be applied in any depth.

### Brief Description of Drawings

The subject matter of the invention will be explained in more detail in the following text with reference to the attached drawings, in which:
- FIG 1: shows a prior art insulated gate semiconductor device having an enhancement layer and trench gate electrode;
- FIG 2: shows an inventive insulated gate semiconductor device having a delta enhancement layer embedded in the base layer;
- FIG 3: shows an another inventive insulated gate semiconductor device having a delta enhancement layer between base layer and drift layer;
- FIG 4: shows an inventive insulated gate semiconductor device having a delta enhancement layer embedded in the drift layer;
- FIG 5: shows another inventive insulated gate semiconductor device with a further delta enhancement layer;
- FIG 6: shows another inventive insulated gate semiconductor device with a further enhancement layer;
- FIG 7: shows another inventive insulated gate semiconductor device having a delta enhancement layer, which is laterally separated from the trench gate electrode;
- FIG 8: shows an inventive insulated gate semiconductor device having a shaped delta enhancement layer with different thicknesses;
- FIG 9: shows another inventive insulated gate semiconductor device having a perforated delta enhancement layer;
- FIG 10: shows the electron current densities of a prior art IGBT without enhancement layer, of a CSTBT (with conventional enhancement layer) and of an inventive IGBT having a delta enhancement layer within the base layer; and
- FIG 11: shows the breakdown voltage V_{br} versus collector-emitter on voltage V_{ce, on} of a prior art CSTBT and various inventive IGBTs;
- FIG 12: shows the switching off energy losses E_{off} for a prior art trench IGBT, a prior art CSTBT and an inventive IGBT (called SBBT);
- FIG 13: shows the doping concentrations of a prior art trench IGBT, a prior art CSTBT and an inventive IGBT (called SBBT); and
- FIG 14: shows the doping concentrations of inventive IGBTs having a single and a double delta enhancement layer.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

In Fig. 2 an inventive insulated gate power semiconductor device is shown in form of an insulated gate bipolar transistor 1, which comprises an emitter electrode 2 on an emitter side 22 and a collector electrode 25 on a collector side 27, which collector side 27 is arranged opposite to the emitter side 22. An (n-) doped drift layer 5 is arranged between the emitter side 22 and the collector side 27. A p doped base layer 4 is arranged between the drift layer 5 and the emitter side 22. The base layer 4 contacts the emitter electrode 2. At least one n doped source region 3 is arranged on the emitter side 22.

The device comprises at least two trench gate electrodes 7, each of which having an electrically conductive layer 75 and a first electrically insulating layer 72, which surrounds and thus separates the electrically conductive layer 75 from the drift layer 5, the base layer 4 and the at least one source region 3. Typically, a second insulating layer 74 is arranged between the electrically conductive layer 75 and the emitter electrode 2. The trench gate electrode 7 is arranged lateral to the base layer 4 in a plane parallel to the emitter side 22. The trench gate electrode 7 extends from the emitter side 22 up to a trench gate electrode depth 77. The figures 2-8 show a half cell of the devices, i.e. the figures have to be mirrored at the left side to show the device with two trench gate electrodes 7.

The source region 3 is embedded into the base layer 4 such that the source region 3 contacts the emitter electrode 2. The source regions 3 may be arranged such that a source region 3 is arranged at both sides of each gate electrode 7 or the source regions may be omitted at some trench gate electrodes 7, i.e. a trench gate electrode 7 may not be in touch with a source region 3 at all or may be in touch with a source region 3 only on one side.

On the collector side 27 a p doped collector layer 6 is arranged. An n doped buffer layer 55 having higher doping concentration than the drift layer 5 may be arranged between the drift layer 5 and the collector layer 6.

An n doped delta enhancement layer 8 having higher doping concentration than the drift layer 5 is arranged between such two trench gate electrodes 7 in a region deeper from the emitter side 22 than the at least one source region 3 and shallower than the trench gate electrode depth 77. The delta enhancement layer 8 is buried within the base layer 4, the drift layer 5 or between the base layer 4 and the drift layer 5.

The delta enhancement layer 8 has a thickness tₙ 82 perpendicular to the emitter side 22 of at most 0.5 µm. In an exemplary embodiment the delta enhancement layer thickness 82 is at most 0.2 µm, in particular of at most 0.1 µm.

The delta enhancement layer 8 is buried from the emitter side 22. Buried shall mean that the delta enhancement layer 8 is arranged within a layer, i.e. covered by a layer towards the emitter side 22, and not arranged on the surface of the semiconductor wafer, e.g. not contacted by the emitter electrode 2. The delta enhancement layer 8 is completely covered by another layer (part of drift layer 5 and/or base layer 4) towards the emitter side 22.

The doping concentration of the source region 3 is higher than of the base layer 4. Exemplarily, the doping concentration of the delta enhancement layer is 8 lower than of the source region 3. Exemplary doping concentrations for the source region 3 higher than 1*10¹⁸ cm⁻³ and smaller than 1*10²¹ cm⁻³, exemplarily between 1*10¹⁹ cm⁻³ and 5*10¹⁹ cm⁻³.

In an examplary embodiment, the delta enhancement layer doping concentration of an inventive device may be significantly higher than of the prior art CSTBT devices. A maximum doping concentration of the delta enhancement layer higher than 1*10¹⁶ cm⁻³, higher than 2*10¹⁶ cm⁻³ or even higher than 1*10¹⁷ cm⁻³ may be chosen.

The doping concentration of the base layer 4 and the drift layer 5 can be freely chosen due to the application needs and the rules for the doping concentrations given above. For devices above 600 V the doping concentration of the drift layer is typically below 5*10¹⁴ cm⁻³. The base layer 4 exemplarily has a doping concentration below 2*10¹⁸ cm⁻³.

The base layer 4 may be splitted into a first and a second sublayer 42, 44, wherein the sublayers are arranged one above each other in a plane parallel to the emitter side 22. The first sublayer 42 is arranged closer to the emitter side 22 than the second sublayer 44. The delta enhancement layer 8 may thus be buried within the base layer 4 between the first and the second sublayer 42, 44. The delta enhancement layer 8 may be buried to a maximum depth from the emitter side 22 of at most 5 µm, in particular 2.5 µm, in particular 2 µm or in particular 1.5 µm. The delta enhancement layer 8 may be arranged within the base layer 4 in a depth of at least 0.5 µm.

For such an arrangement of the delta enhancement layer 8 within the base layer 8, the emitter efficiency of the delta enhancement layer acting as a bipolar emitter is advantageously limited to 5 to 10 % or even lower than 1 % in order to suppress undesired bipolar effects (for devices in which short-circuit capability is required). This effect is achieved if the total charge of the delta enhancement layer 8 is 3 to 6 times smaller than the charge of the second sublayer 44 of the base layer. Therefore, the delta enhancement layer 8 may exemplarily be positioned close to the emitter side 22 so that a large part of the base layer 4 is formed by the second sublayer 44. In order to achieve an even lower emitter efficiency of at most 1 % the ratio between the charge in the second sublayer 44 and delta enhancement layer 8 is set at least to 30.

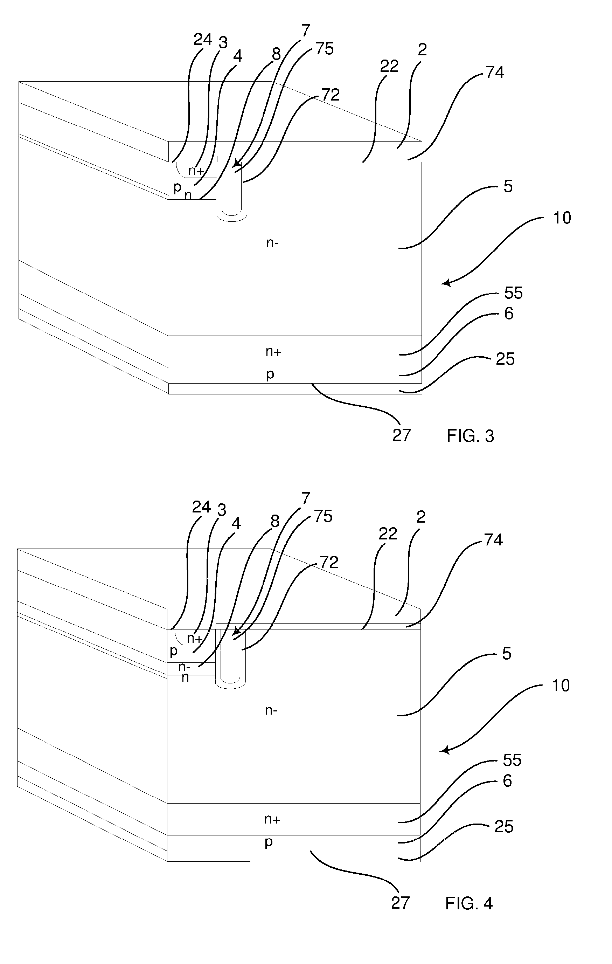

Alternatively to an arrangement of the delta enhancement layer 8 within the base layer 4, the delta enhancement layer 8 may be arranged between the base layer 4 and the drift layer 5 (Fig. 3) or even within the drift layer 5 (Fig. 4), in which case there is no regenerative npnp layer structure so that the emitter efficiency is not influenced by the delta enhancement layer 8. In case of a shallow base layer 4 or a highly doped base layer 4 it may be advantageous to place the enhancement layer 8 within the drift layer 5.

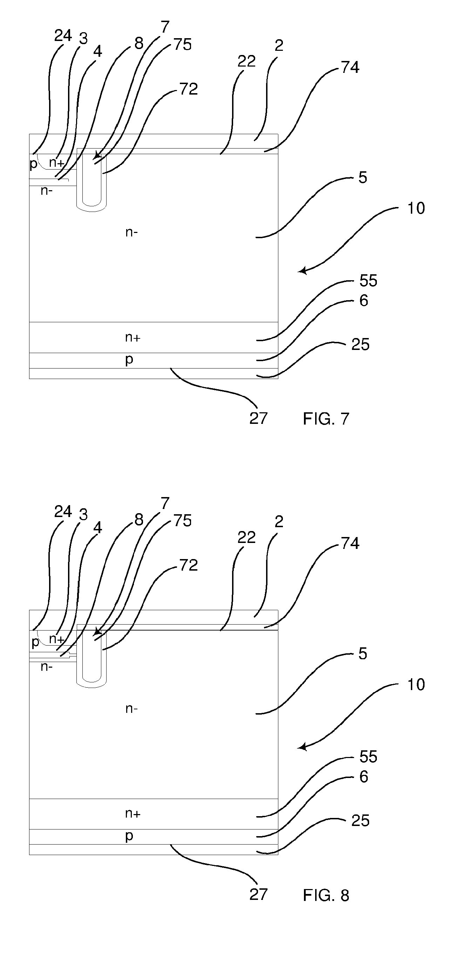

Laterally, the delta enhancement layer 8 may be in touch with at least one trench gate electrode 7 (i.e. with its first insulating layer 72) or with both trench gate electrodes 7, between which the delta enhancement layer 8 is arranged. Alternatively, as shown in FIG. 7, the delta enhancement layer 8 may have a lateral distance from at least one trench gate electrode 7 in a plane parallel to the emitter side 22. This lateral distance may be at most 0.3 µm, in particular at most 0.2 µm. Such a distance between the delta enhancement layer 8 and the trench gate electrode 7 may relax the critical electrical field peaks (lowering or enhancing the peak electric field) between the delta enhancement layer 8 and the trench gate electrode 7 and also around the delta enhancement layer 8. Thereby, the SOA may be improved. However, V_{ce}, on increases at greater distances between delta enhancement layer 8 and trench gate electrode 7 so that a maximum lateral distance as given above is exemplarily applied.

In a further exemplary embodiment, the delta enhancement layer 8 comprises in a plane parallel to the emitter side a central zone of higher thickness (at most 0.5 µm) and an outer zone (towards the gate electrode 7), which surrounds the inner zone in a plane parallel to the emitter side, of lower thickness (FIG. 8). By such a design, the SOA may be less improved than for an delta enhancement layer with an offset to the trench gate electrode 7, whereas V_{ce}, on is advantageously lower. The lower zone of the delta enhancement layer may exemplarily have a thickness of at most 0.1 µm.

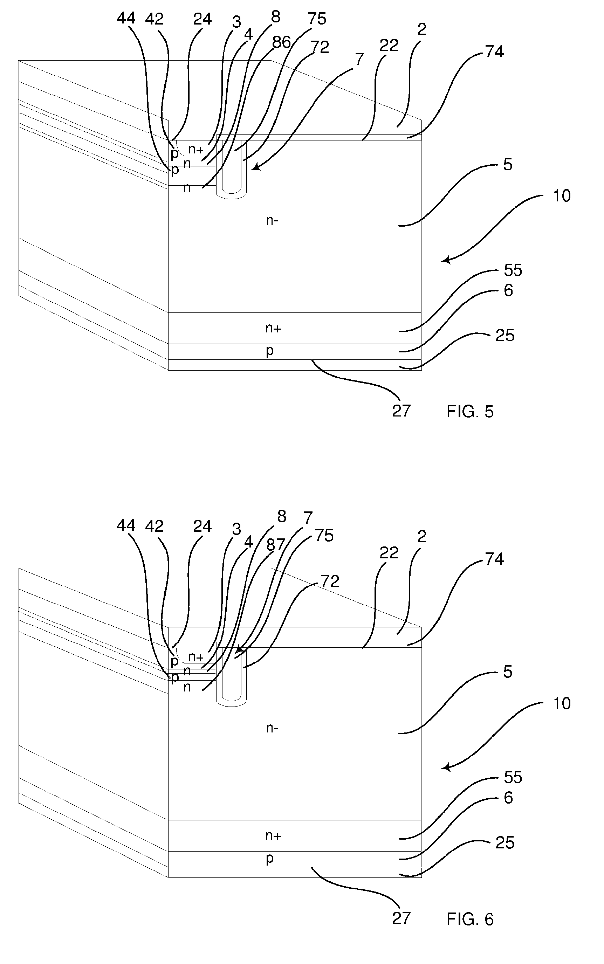

The inventive device may also comprise more than one enhancement layer. The further enhancement layer(s) 86, 87 is (are) arranged in another depth from the emitter side than the enhancement layer 8. The further enhancement layer 86 can be designed like the delta enhancement layer 8 to have a thickness of at most 0.5 µm (Fig. 5). FIG 14 shows the dopant concentrations for a single delta enhancement layer 8 and a double delta enhancement layers 8, 86. Alternatively, it can be designed to have a higher thickness, e.g. at least 2 µm like enhancement layers as known from prior art devices (Fig. 6). In the latter case the further enhancement layer 87 is placed between the base layer 4 and the drift layer 5 due to its manufacturing process as described in the prior art section of this patent application.

The delta enhancement layer 8 may also be perforated in a plane parallel to the emitter side (FIG. 9, in which figure only the delta enhancement layer 8 is shown). That means that the delta enhancement layer 8 may be designed as a layer with through holes 81, which holes are filled by the attached layers (base and/or drift layer 4, 5). Such a device is a trade-off between SOA improvement and less effective lowering of the on-state voltage V_{ce}, on.

The structures as described above form an active cell. The IGBT device may comprise only one active cell as disclosed above, but it is also possible that the device comprises at least two or more such active cells, i.e. the active cells can be repetitively arranged in one wafer.

The inventive delta enhancement layer 8 can be integrated into many different semiconductor device types. In the figures, the integration of the inventive delta enhancement layer 8 in an IGBT is shown. Of course, the delta enhancement layer 8 can be integrated into IGBT variants like a reverse conducting IGBT, in which on the collector side 27 the collector layer 6 is placed and in the same plane lateral to the collector layer 6 an n doped layer is arranged. Thus, the n doped layer alternates with the collector layer 6. Such devices are well-known to the experts in the field.

The inventive delta enhancement layer 8 can also be applied to super-junction IGBTs as exemplarily known by EP 10167819.1, in which on the emitter side a plurality of n doped layer and p doped base layers alternate in a plane parallel to the emitter side.

Furthermore, such inventive delta enhancement layer can also be applied to MOSFETs, JFETs, thyristors and their super-junction variants.

For manufacturing an inventive insulated gate power semiconductor device the following steps are performed for the creation of layers on the emitter side 22.

An (n-) doped wafer having a first and second side opposite to the first side is provided. The wafer may be made on a basis of a silicon or GaN or SiC wafer. Such part of wafer having unamended doping concentration in the finalized device forms a drift layer 5. For forming a base layer 4 p dopants are applied on the first side. The p dopants are diffused into the wafer.

Then n type dopants are implanted into the wafer on the first side. For forming an delta enhancement layer 8 the dopants are annealed/electrically activated without significantly diffusing the dopants into the wafer such that the delta enhancement layer 8 has a thickness tₙ 82 of at most 0.5 µm. Such a thin thickness can exemplarily be achieved by rapid thermal annealing (RTA).

In an RTA process a single wafer is heated examplarily by a lamp based heating, a hot chuck, or a hot plate to which the wafer is brought close to. This results in a high heat transfer in a very short time so that the dopants are annealed without diffusing them significantly into greater depths in the wafer. In the anneal step, defects introduced by the implantation are removed and dopants are activated with little movement of the dopants. As a result, as all dopant distributions in the device are already fixed and in place, the RTA step activating the delta enhancement layer represents the final high temperature step in the process line-up without any significant co-diffusion of p-base layer 4, n-source region 3 etc.

Then n type dopants for creation of the source regions 3 are implanted on the first side and annealed. On the second side, p type dopants are implanted and annealed for the creation of the collector layer 6.

Alternatively to the process disclosed above, it is also possible to implant dopants for all or at least part of the shallow layers first, e.g. for the source regions 3, the delta enhancement layer 8 on the first side and the collector layer 8 on the second side or for at least two of these layers, and then anneal all dopants in one step. A co-activation of delta enhancement layer 8 and collector side collector layer 6 may be advantageous if a shallow p-collector layer 6 is desired (low injection efficiency on the collector side).

In the case of the final device having at least two delta enhancement layers 8, 86 these layer can also be created by implanting dopants during one implant step without breaking the vacuum (using different energies for implanting the dopants into different depths) and it is also possible to anneal the dopants for the at least two delta enhancement layers 8, 86 in one step.

The further enhancement layer can have any thickness, i.e. it may also have a thickness in the range between 0.5 µm and 2 µm.

If the device comprises a further enhancement layer 87 like the prior art enhancement layers between base and drift layer 4, 5, such a layer 87 has to be created before the inventive delta enhancement layer 8.

For an inventive device having an delta enhancement layer which comprises in a plane parallel to the emitter side a central zone of higher thickness and an outer zone of lower thickness (FIG. 8), an additional masking step is needed for the creation of the shaped delta enhancement layer (having a thicker inner and a thinner outer zone).

The layers on the collector side 27 of the device and the gate electrode are made by methods well known to the experts (e.g. as described in this application in the prior art section for EP 0 795 911 A2) and finally, after all layers have been created in the wafer, the electrodes 2, 25 are applied as metal layers on both sides of the wafer.

These examples shall not limit the scope of the invention. The above mentioned designs and arrangements are just examples for any kinds of possible designs and arrangements for the enhancement layer(s).

In another embodiment, the conductivity types are switched, i.e. all layers of the first conductivity type are p type (e.g. the drift layer 5, the source region 3) and all layers of the second conductivity type are n type (e.g. base layer 4, the collector layer).

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

### Reference List

- 1: Inventive IGBT
- 10: Prior art IGBT
- 2: emitter electrode
- 22: emitter side
- 24: contact area
- 25: collector electrode
- 27: collector side
- 3: source region
- 4: base layer
- 42: first sublayer
- 44: second sublayer
- 5: drift layer
- 55: buffer layer
- 6: collector layer
- 7: trench gate electrode
- 72: first insulating layer
- 74: second insulating layer
- 75: electrically conductive layer
- 77: trench gate electrode depth
- 8: delta enhancement layer
- 81: through-hole
- 82: delta enhancement layer thickness tₙ
- 84: delta enhancement layer depth dₙ
- 86: further delta enhancement layer
- 87: thick further enhancement layer
- 88: enhancement layer of a prior art device

## Claims

1. Insulated gate power semiconductor device (1) having
- an emitter electrode (2) on an emitter side (22) and a collector electrode (25) on a collector side (27), which collector side (27) is arranged opposite to the emitter side (22),
- a drift layer (5) of a first conductivity type, which is arranged between the emitter side (22) and the collector side (27),
- a base layer (4) of a second conductivity type, which is different from the first conductivity type, which base layer (4) is arranged between the drift layer (5) and the emitter side (22), and which base layer (4) contacts the emitter electrode (2),
- at least one source region (3), which is arranged on the emitter side (22) and which contacts the emitter electrode (2),
- at least two trench gate electrodes (7), each of which comprises an electrically conductive layer (75) and a first electrically insulating layer (72), which surrounds and thus separates the electrically conductive layer (75) from the drift layer (5), the base layer (4) and the at least one source region (3), wherein the trench gate electrode (7) is arranged laterally to the base layer (4) in a plane parallel to the emitter side (22), and which trench gate electrode (7) extends from the emitter side (22) up to a trench gate electrode depth (77),
- a delta enhancement layer (8) of the first conductivity type having higher doping concentration than the drift layer (5), which is arranged between two trench gate electrodes (7) in a region deeper from the emitter side (22) than the at least one source region (3) and shallower than the trench gate electrode depth (77) and buried within at least one of or between the base layer (4) and the drift layer (5),
wherein the delta enhancement layer (8) has a thickness tₙ (82) perpendicular to the emitter side (22) of at most 0.5 µm.

2. Insulated gate power semiconductor device according to claim 1, **characterized in that** the base layer (4) comprises a first sublayer (82) and a second sublayer (84), one above each other in planes parallel to the emitter side (22) and **in that** the delta enhancement layer (8) is arranged between the first and second sublayer (42, 44).

3. Insulated gate power semiconductor device according to claim 1, **characterized in that** the delta enhancement layer (8) has a thickness tₙ (82) of less than 0.2 µm, in particular of less than 0.1 µm.

4. Insulated gate power semiconductor device according to claim 1, **characterized in that** the delta enhancement layer (8) has a maximum doping concentration, which is higher than 1*10¹⁶ cm⁻³, in particular higher than 2*10¹⁶ cm⁻³ and in particular higher than 1*10¹⁷ cm⁻³.

5. Insulated gate power semiconductor device according to claim 1, **characterized in that** the delta enhancement layer (8) is in touch with at least one trench gate electrode (7).

6. Insulated gate power semiconductor device according to claim 1, **characterized in that** the delta enhancement layer (8) is buried up to a maximum depth (84) from the emitter side (22) of at most 5 µm, in particular at most 2.5 µm or in particular at most 1.5 µm.

7. Insulated gate power semiconductor device according to claim 1, **characterized in that** the delta enhancement layer (8) has a lateral distance from at least one trench gate electrode (7) in a plane parallel to the emitter side (22) and **in that** the lateral distance is smaller than 0.3 µm, in particular smaller than 0.2 µm.

8. Insulated gate power semiconductor device according to claim 1, **characterized in that** the delta enhancement layer (8) comprises in a plane parallel to the emitter side (22) a central zone of higher thickness and an outer zone of lower thickness.

9. Insulated gate power semiconductor device according to claim 1, **characterized in that** the delta enhancement layer (8) is perforated in a plane parallel to the emitter side (22).

10. Insulated gate power semiconductor device according to claim 1, **characterized in that** the device comprises a further enhancement layer (86, 87), which is arranged in another depth from the emitter side (22) than the delta enhancement layer (8).

11. Insulated gate power semiconductor device according to claim 1, **characterized in that** the further enhancement layer is a further delta enhancement layer (86) having a thickness of at most 0.5 µm or that the further enhancement layer (87) has a thickness of at least 2 µm.

12. Insulated gate power semiconductor device according to claim 1, **characterized in that** the device is one of a thyristor, a MOSFET, an IGBT, in particular a reverse conducting IGBT or a super-junction version of one of these semiconductor devices.

13. Method for manufacturing an insulated gate power semiconductor device, which method comprises the following steps:
- providing a wafer of a first conductivity type having a first and second side opposite to the first side, such part of wafer having unamended doping concentration in the finalized device forming a drift layer (5),
- applying dopants of a second conductivity type, which is different from the first conductivity type, on the first side,
- forming a base layer (4) by diffusing the dopants into the wafer,
- implanting dopants of the first conductivity type into the wafer on the first side,
- forming a delta enhancement layer (8) by annealing the dopants such that the delta enhancement layer (8) has a thickness (82) of at most 0.5 µm.

14. Method according to claim 12, **characterized in, that** performing the annealing by rapid thermal annealing.

15. Method according to claim 12 or 13, **characterized in that** the bipolar device (1) is made on a basis of a silicon or GaN or SiC wafer.
